# EUROPEAN PATENT SPECIFICATION

(11) **EP 2 608 646 B1**
(45) Date of publication and mention of the grant of the patent: **09.04.2014**
(21) Application number: 12191067.3
(22) Date of filing: 02.11.2012
(51) Int. Cl.: H05K 7/14, F16L 3/10, H02G 3/32, H02G 3/04

(54) **Cable arrangement device for cable management arm**
Kabelanordnungsvorrichtung für einen Kabelverwaltungsarm
Dispositif d'agencement pour bras de gestion de câble

(30) Priority: 23.12.2011 TW 100148499
(43) Date of publication of application: 26.06.2013
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Yang, Cheng-Hui, Kaohsiung City (TW); Wang, Chun-Chiang, Kaohsiung City (TW)
(74) Representative: Viering, Jentschura & Partner Patent- und Rechtsanwälte

(56) References cited:
- US-A- 4 669 688
- US-A- 5 961 081
- US-A1- 2010 008 608
- US-A1- 2010 282 932

## Description

The present invention relates to a cable arrangement device for a cable management arm, and more particularly, to a cable arrangement device for quickly positioning or detaching the cables relative to the cable management arm.

### BACKGROUND OF THE INVENTION

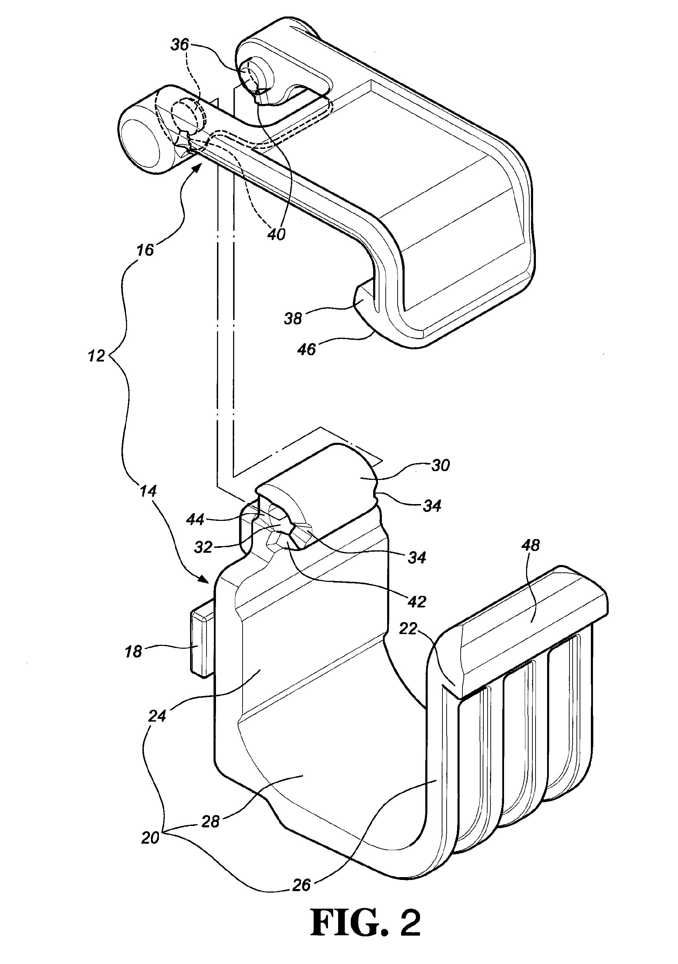

U.S. Pat. No. 7,473,846 to Doerr discloses a "Reversible cable support arm" and a cable support arm 24 is connected to the rails 108 as shown in Figs. 2 to 11, wherein the cable support arm 24 has multiple cable support features 48 which are a U-shaped metal wire and one side of the U-shaped wire is fixed to the cable support arm 24 and the other side of the U-shaped wire is located to form an L shape arrangement with the horizontal section of the U-shaped metal wire so as to accommodate and support the cables.

However, the cable support features 48 of the cable support arm 24 are a hook-like member facing upward, the cables can be quickly positioned, the cables may drop from the open top.

When using the cable support arm 24, the two ends of the cable support arm are pulled to be straight or bent to be overlapped to each other. Obviously, the cables on the cable support arm will be pulled or bent. That is to say, the cables are easily shifted or deformed relative to the cable support features and drop from the open top of the cable support features.

The other examples of cable arrangement devices are known from documents US 2010/282932, US2010/008608, US4669688 and US5961081.

The present invention intends to provide a cable arrangement device to improve the shortcomings mentioned above.

### SUMMARY OF THE INVENTION

The present invention relates to a cable arrangement device for a cable management arm according to claim 1.

The primary object of the present invention is to provide a cable arrangement device for a cable management arm so as to improve the shortcoming of the conventional cable arrangement device wherein the cables are easily dropped from the cable support features.

Preferably, the first pivotal portion of the connection member of the accommodation portion is located above the first sidewall so that when the locking member is opened, the first pivotal portion is located upright above the first sidewall.

Preferably, the connection member has a second recess. When the locking member is locked with the support member, the second pivotal portion of the locking member is engaged with the first pivotal portion of the connection member of the support member via the second recess.

Preferably, the hook portion is a hook.

Preferably, the engaging portion of the locking member is a hook which is located corresponding to the hook portion.

Preferably, the engaging portion of the locking member includes an inclined surface which is located corresponding to the hook portion.

Preferably, the hook portion of the support member includes an inclined surface which is located corresponding to the engaging portion.

When the locking member is engaged with the support member, the engaging portion the locking member is engaged with the hook portion of the support member, and in the meanwhile, the engaging feature of the locking member is engaged with the first recess of the support member. When the user opens the cable arrangement device to take the cables, the cable arrangement device is slightly engaged with the second sidewall to let the second sidewall of the support member be deformed toward the first sidewall. The hook portion on the second sidewall is then disengaged from the engaging portion, and the locking member is rotated. The engaging feature is disengaged from the first recess and is engaged with the positioning feature. The locking member is positioned upright so that the cables can be easily installed in the cable arrangement device, or removed from the cable arrangement device. Because the locking member is positioned upright, the cables are not impeded by the locking member.

The present invention will become more obvious from the following description when taken in connection with the accompanying drawings which show, for purposes of illustration only, a preferred embodiment in accordance with the present invention.

### BRIEF DESCRIPTION OF THE DRAWINGS

Fig. 1 is a perspective view to show that the cable arrangement device of the present invention is cooperated with a cable management arm;
Fig. 2 is an exploded view to show the cable arrangement device of the present invention;
Fig. 3 is a perspective view to show the cable arrangement device of the present invention;
Fig. 4 shows that locking member of the cable arrangement device of the present invention is engaged with the support member, and
Fig. 5 shows that locking member of the cable arrangement device of the present invention is released and the firs sidewall that is located upright is opened.

### DETAILED DESCRIPTION OF THE PREFERRED EMBODIMENT

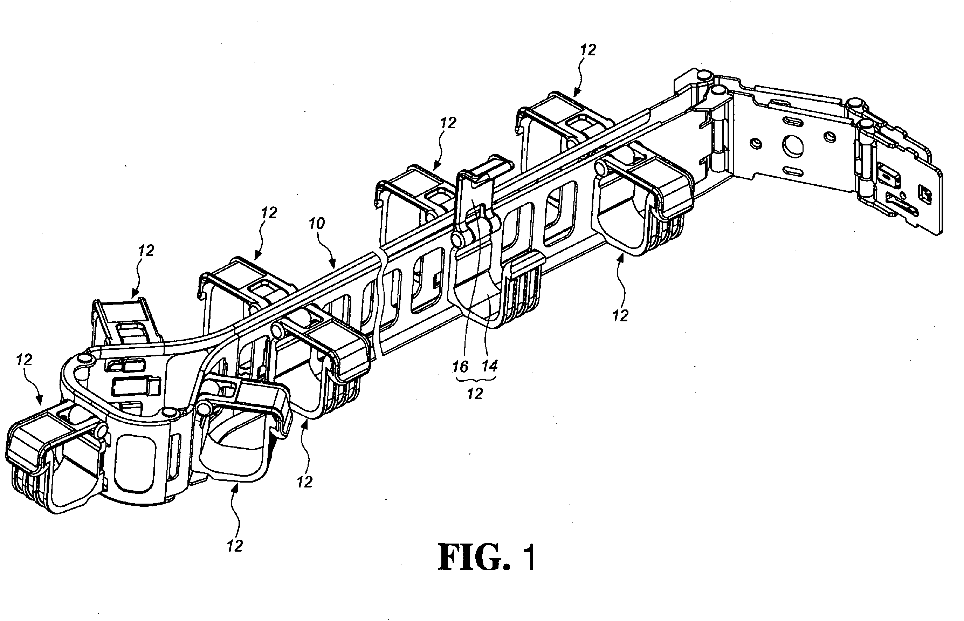

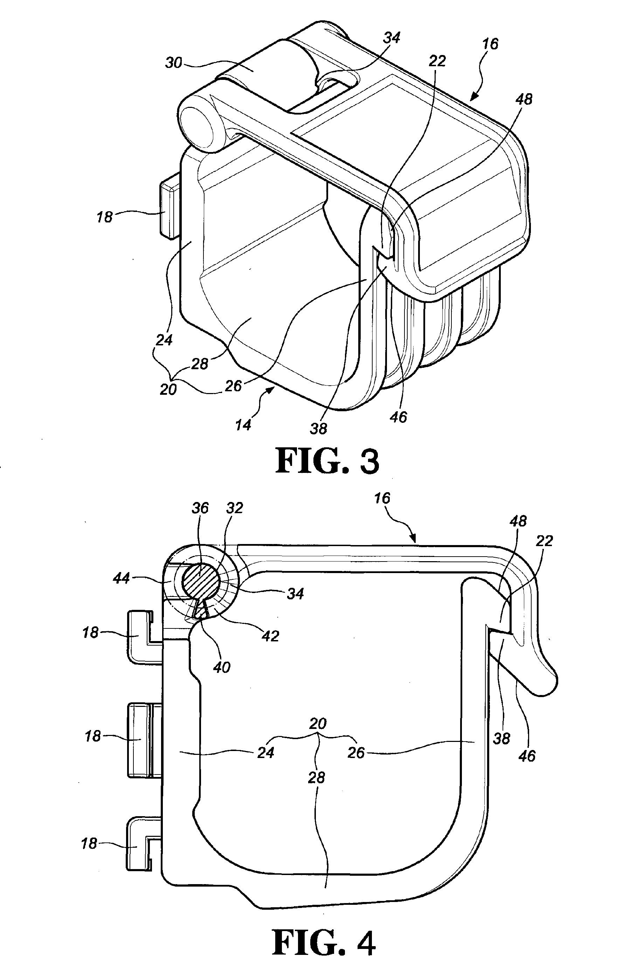

Referring to Figs. 1 to 3, the cable arrangement device 12 of the present invention comprises a support member 14 and a locking member 16 pivotably connected to the support member 14. As shown in Figs. 2 and 3, the support member 14 has a fixing portion 18, an accommodation portion 20 and a hook portion 22. The accommodation portion 20 has a first sidewall 24, a second sidewall 26 and a bottom wall 28 connected between the first and second sidewalls 24, 26. The first sidewall 24, the second sidewall 26 and the bottom wall 28 define a U-shaped body. The first sidewall 24 is fixed to the fixing portion 18, for example, the fixing portion 18 extends from the first sidewall 24. In a preferable embodiment, the first sidewall 24 has a connection member 30 which has a first pivotal portion 32. For example, the first pivotal portion 32 is a hole. The first pivotal portion 32 has a positioning feature 34 defined in a periphery thereof. For example, the positioning feature 34 is a recess. The second sidewall 26 is fixed to the hook portion 22 which extends from the second sidewall 26. Because the accommodation portion 20 is a U-shaped body so that the second sidewall 26 is flexible relative to the first sidewall 24, and the hook portion 22 on the second sidewall 26 is able to change its position relative to the first sidewall 24 in resilient form.

The locking member 16 has a second pivotal portion 36 and an engaging portion 38, wherein the second pivotal portion 36 is a protrusion and pivotably connected to the first pivotal portion 32 of the support member 14. The second pivotal portion 36 has an engaging feature 40 defined in a periphery thereof, for example, the engaging feature 40 is a protrusion and engaged with the positioning feature 34 of the connection member 30. The engaging portion 38 is engaged with the hook portion 22 of the support member 14 when the engaging portion 38 is in locked position.

The first pivotal portion 32 of the connection member 30 of the accommodation portion 20 is located above the first sidewall 24 so that when the locking member 16 is opened, the first pivotal portion 32 is located upright above the first sidewall 24.

The connection member 30 has a first recess 42 and a second recess 44. When the engaging portion 38 of the locking member 16 is locked with the hook portion 22 of the support member 14, the engaging feature 40 is engaged with the first recess 42 so that the locking member 16 is not disengaged from the support member 14 due to be expanded. Alternatively, when the locking member 16 is locked with the support member 14, the second pivotal portion 36 of the locking member 16 is connected with the first pivotal portion 32 of the connection member 30 of the support member 14 via the second recess 44.

The hook portion 22 is a hook and the engaging portion 38 of the locking member 16 is a hook which is located corresponding to the hook portion 22.

The engaging portion 38 of the locking member 16 includes an inclined surface 46 which is located corresponding to the hook portion 22. The hook portion 22 of the support member 14 includes an inclined surface 48 which is located corresponding to the engaging portion 38.

As shown in Fig. 4, when in operation, the locking member 16 is engaged with the support member 14, and the engaging portion 38 of the locking member 16 is located corresponding to the hook portion 22 of the support member 14 and hook to the hook portion 22. The engaging feature 40 of the locking member 16 engages with the first recess 42 so that the pivotal connection between the locking member 16 and the support member 14 is not released due to being expanded.

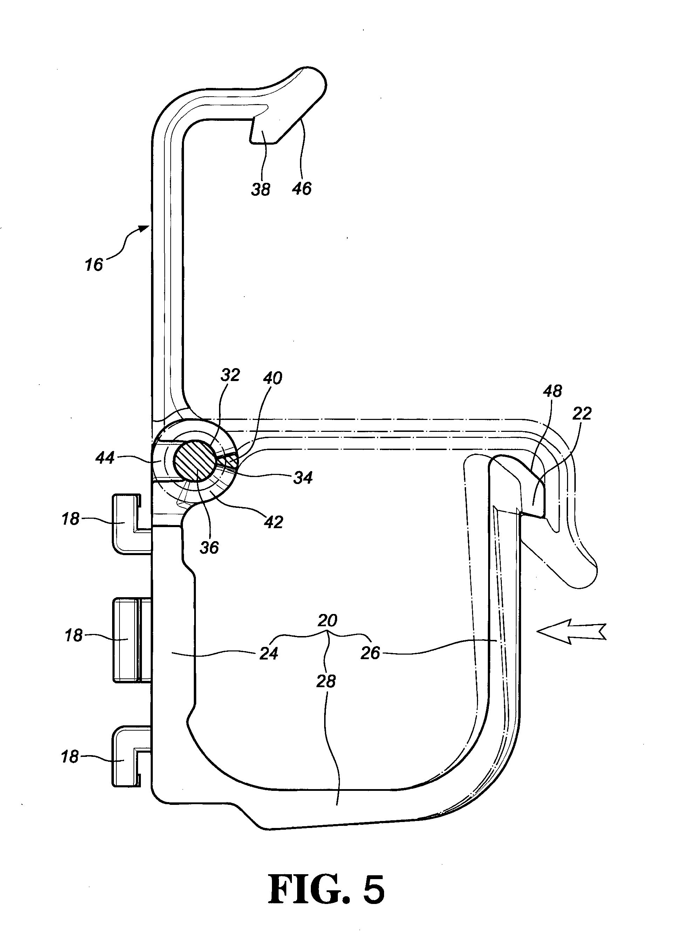

As shown in Fig. 5, when in operation, the locking member 16 is released and opens the upright first sidewall 24 of the support member 14. When the user slightly presses the cable arrangement device 12 onto the second sidewall 26, the second sidewall 26 is deformed resiliently toward the first sidewall 24 and the hook portion 22 of the second sidewall 26 is disengaged from the engaging portion 38 of the locking member 16. The locking member 16 is rotated so that the engaging feature 40 of the locking member 16 is removed from the first recess 42 and engaged with the positioning feature 34 to temporarily position the locking member 16 upright. Therefore, the user can easily position the cables (not shown) in the cable arrangement device 12 or remove the cables (not shown) from the cable arrangement device 12. Because the locking member 16 is temporarily positioned, the locking member 16 does not impede the positioning of the cables. Especially, as shown in Fig. 1, when there are multiple cable arrangement devices 12 connected to the cable management arm 10, each cable arrangement device 12 temporarily positions the locking member 16 upright, so that the cables (not shown) are conveniently positioned in the cable arrangement devices 12 one by one.

While we have shown and described the embodiment in accordance with the present invention, it should be clear to those skilled in the art that further embodiments may be made without departing from the scope of the present invention.

## Claims

1. A cable arrangement device (12) for a cable management arm (10), comprising:
a support member (14) having a fixing portion (18), an accommodation portion (20) and a hook portion (22), the accommodation portion (20) having a first sidewall (24), a second sidewall (26) and a bottom wall (28) connected between the first and second sidewalls (24, 26), the first sidewall (24) fixed to the fixing portion (18) and having a connection member (30), the connection member (30) having a first pivotal portion (32) which has a positioning feature (34) defined in a periphery thereof, the second sidewall (26) fixed to the hook portion (22), and
a locking member (16) having a second pivotal portion (36) and an engaging portion (38), the second pivotal portion (36) pivotably connected to the first pivotal portion (32) of the support member (14), the second pivotal portion (36) having an engaging feature (40) defined in a periphery thereof, the engaging feature (40) engaged with the positioning feature (34) of the connection member (30), the engaging portion (38) being engaged with the hook portion (22) of the support member (14) when the locking member (16) is in locked position,
wherein the first pivotal portion (32) of the connection member (30) of the support member (14) and the second pivotal portion (36) of the locking member (16) are a hole and a protrusion respectively, and
wherein the positioning feature (34) of the connection member (30) of the support member (14) is a recess and the engaging feature (40) of the second pivotal portion (36) of the locking member (16) is a protrusion,
wherein the connection member (30) has a first recess (42) with which the engaging feature (40) is engaged when the engaging portion (38) of the locking member (16) is locked with the hook portion (22) of the support member (14),
when the engaging portion (38) of the locking member (16) is disengaged from the hook portion (22) of the support member (14) the locking member (16) is rotated so that the engaging feature (40) of the locking member (16) is removed from the first recess (42) and engaged with the positioning feature (34) to temporarily position the locking member (16) upright.

2. The device as claimed in claim 1, wherein the first pivotal portion (32) of the connection member (30) of the accommodation portion (20) is located above the first sidewall (24).

3. The device as claimed in claim 1, wherein the connection member (30) has a second recess (44), when the locking member (16) is locked with the support member (14), the second pivotal portion (36) of the locking member (16) is engaged with the first pivotal portion (32) of the connection member (30) of the support member (14) via the second recess (44).

4. The device as claimed in claim 1, wherein the hook portion (22) is a hook.

5. The device as claimed in claim 4, wherein the engaging portion (38) of the locking member (16) is a hook which is located corresponding to the hook portion (22).

6. The device as claimed in claim 5, wherein the engaging portion (38) of the locking member (16) includes an inclined surface (46) which is located corresponding to the hook portion (22).

7. The device as claimed in claim 6, wherein the hook portion (22) of the support member (14) includes an inclined surface (48) which is located corresponding to the engaging portion (38).

## Patentansprüche

1. Eine Kabelwicklungsvorrichtung (12) für einen Kabelaufwickelarm (10), aufweisend:
einem Stützelement (14) mit einem Befestigungselement (18), einem Aufnahmeteil (20) und mit einem Hakenteil (22); das Aufnahmeteil (20) eine erste Seitenwand (24), eine zweite Seitenwand (26) und eine Bodenfläche (28) aufweist, wobei letztere zwischen der ersten Seitenwand (24) und der zweiten Seitenwand (26) gebildet ist; das Befestigungselement (18) an der ersten Seitenwand (24) befestigt ist, wobei diese erste Seitenwand (24) mit einem Montageelement (30) gebildet ist; das Montageelement (30) ein Drehloch (32) aufweist, das auf dessen Peripherie mit einer Positionierkerbe (34) gebildet ist; die zweite Seitenwand (26) am Hakenteil (22) befestigt ist; und
einem Verriegelungselement (16) mit einem Drehzapfen (36) und einem Eingreifteil (38); der Drehzapfen (36) drehgelenkig im Drehloch (32) des Stützelements (14) befestigt ist; ein einrückender Vorsprung (40) auf der Peripherie des Drehzapfens (36) gebildet ist; der einrückende Vorsprung (40) in die Positionierkerbe (34) des Montageelements (30) einrückt; das Eingreifteil (38) mit dem Hakenteil (22) des Stützelements (14) eingerückt wird, wenn das Verriegelungselement (16) verriegelt ist;
wobei das Drehloch (32) am Montageelement (30) des Stützelements (14) und der Drehzapfen (36) am Verriegelungselement (16) als ein Loch bzw. als ein Vorsprung gebildet sind; und
wobei die Positionierkerbe (34) am Montageelement (30) des Stützelements (14) als eine Ausnehmung und der einrückende Vorsprung (40) des Drehlochs (36) im Verriegelungselement (16) als einen Vorsprung gebildet sind;
wobei das Montageelement (30) eine erste Ausnehmung (42) aufweist, in die der einrückende Vorsprung (40) eingreift, wenn das Eingreifteil (38) am Verriegelungselement (16) mit dem Hakenteil (22) des Stützelements (14) verriegelt wird;
beim Ausrücken des Eingreifteils (38) am Verriegelungselement (16) aus dem Hakenteil (22) des Stützelements (14) wird das Verriegelungselement (16) rotiert, so dass der einrückende Vorsprung (40) am Verriegelungselement (16) aus der ersten Ausnehmung (42) ausrückt und in die Positionierkerbe (34) einrückt, um das Verriegelungselement (16) vorübergehend aufrecht zu positionieren.

2. Die Vorrichtung nach Anspruch 1, wobei das Drehloch (32) im Montageelement (30) des Aufnahmeteils (20) sich über der ersten Seitenwand (24) befindet.

3. Die Vorrichtung nach Anspruch 1, wobei das Montageelement (30) eine zweite Ausnehmung (44) aufweist, wenn das Verriegelungselement (16) mit dem Stützelement (14) verriegelt ist; der Drehzapfen (36) des Verriegelungselements (16) durch die zweite Ausnehmung (44) in das Drehloch (32) im Montageelement (30) des Stützelements (14) eingerückt wird.

4. Die Vorrichtung nach Anspruch 1, wobei das Hakenteil (22) als einen Haken gebildet ist.

5. Die Vorrichtung nach Anspruch 4, wobei das Eingreifteil (38) am Verriegelungselement (16) als einen Haken gebildet ist, der entsprechend dem Hakenteil (22) positioniert ist.

6. Die Vorrichtung nach Anspruch 5, wobei das Eingreifteil (38) am Verriegelungselement (16) entsprechend dem Hakenteil (22) eine abgeschrägte Fläche (46) aufweist.

7. Die Vorrichtung nach Anspruch 6, wobei das Hakenteil (22) am Stützelement (14) entsprechend dem Eingreifteil (38) eine abgeschrägte Fläche (48) aufweist.

## Revendications

1. Un dispositif d'agencement de câbles (12) pour un bras de gestion de câbles (10), comprenant :
un élément de support (14) ayant une partie d'attache (18), une partie de logement (20) et une partie en crochet (22), la partie de logement (20) ayant une première paroi latérale (24), une seconde paroi latérale (26) et une paroi inférieure (28) connectée entre les première et seconde parois latérales (24, 26), la première paroi latérale (24) attachée à la partie d'attache (18) et ayant un élément de connexion (30), l'élément de connexion (30) ayant une première partie d'articulation (32) qui a une fonction de positionnement (34) définie dans sa périphérie, la seconde paroi latérale (26) attachée à la la partie en crochet (22), et
un élément de verrouillage (16) ayant une seconde partie d'articulation (36) et une partie d'engagement (38), la seconde partie d'articulation (36) reliée de manière pivotante à la première partie d'articulation (32) de l'élément de support (14), la seconde partie d'articulation (36) ayant une fonction d'engagement (40) définie dans sa périphérie, la fonction d'engagement (40) engagée avec la fonction de positionnement (34) de l'élément de connexion (30), la partie d'engagement (38) étant engagée avec la partie en crochet (22) de l'élément de support (14) quand l'élément de verrouillage (16) est en position verrouillée,
dans lequel la première partie d'articulation (32) de l'élément de connexion (30) de l'élément de support (14) et la seconde partie d'articulation (36) de l'élément de verrouillage (16) sont respectivement un trou et une saillie, et
dans lequel la fonction de positionnement (34) de l'élément de connexion (30) de l'élément de support (14) est une cavité et la fonction d'engagement (40) de la seconde partie d'articulation (36) de l'élément de verrouillage (16) est une saillie,
dans lequel l'élément de connexion (30) a une première cavité (42) avec laquelle la fonction d'engagement (40) est engagée quand la partie d'engagement (38) de l'élément de verrouillage (16) est verrouillée avec la partie en crochet (22) de l'élément de support (14),
quand la partie d'engagement (38) de l'élément de verrouillage (16) est désengagée de la partie en crochet (22) de l'élément de support (14), l'élément de verrouillage (16) est tourné de sorte que la fonction d'engagement (40) de l'élément de verrouillage (16) est retirée de la première cavité (42) et engagée avec la fonction de positionnement (34) pour positionner de manière temporaire l'élément de verrouillage (16) en position droite.

2. Le dispositif selon la revendication 1, dans lequel la première partie d'articulation (32) de l'élément de connexion (30) de la partie de logement (20) est située au dessus de la première paroi latérale (24).

3. Le dispositif selon la revendication 1, dans lequel l'élément de connexion (30) a une seconde cavité (44), quand l'élément de verrouillage (16) est verrouillé avec l'élément de support (14), la seconde partie d'articulation (36) de l'élément de verrouillage (16) est engagée avec la première partie d'articulation (32) de l'élément de connexion (30) de l'élément de support (14) par le biais de la seconde cavité (44).

4. Le dispositif selon la revendication 1, dans lequel la partie en crochet (22) est un crochet.

5. Le dispositif selon la revendication 4, dans lequel la partie d'engagement (38) de l'élément de verrouillage (16) est un crochet qui est situé en correspondance avec la partie en crochet (22).

6. Le dispositif selon la revendication 5, dans lequel la partie d'engagement (38) de l'élément de verrouillage (16) inclut une surface inclinée (46) qui est située en correspondance avec la partie en crochet (22).

7. Le dispositif selon la revendication 6, dans lequel la partie en crochet (22) de l'élément de support (14) inclut une surface inclinée (48) qui est située en correspondance avec la partie d'engagement (38).
